# EUROPEAN PATENT APPLICATION

(11) **EP 1 602 980 A2**
(43) Date of publication of application: **07.12.2005**
(21) Application number: 05104310.7
(22) Date of filing: 20.05.2005
(51) Int. Cl.: G03F 7/20, B65D 85/42, F21V 25/12

(54) **Protective cover for a lamp, set including a lamp and a protective cover, method of installing a source in a lithographic apparatus, device manufacturing method and device manufactured thereby**

(30) Priority: 04.06.2004 US 860655
(71) Applicant: ASML Netherlands B.V., 5504 DR Veldhoven (NL)
(72) Inventor: Salden, Koenraad Stephan Silvester, 4818 SM, Breda (NL)
(74) Representative: van Westenbrugge, Andries

(57) **Abstract**

A protective cover (38) for a lamp (2) is flexible and made of a material that has a tensile strength so that the protective cover is impermeable to fragments produced from the lamp when the lamp breaks when covered by the protective cover. The protective cover is used to install the discharge lamp in a source (SO) and removed from the lamp after installing the lamp.

## Description

### BACKGROUND OF THE INVENTION

### 1. Field of the Invention

The present invention relates to a protective cover for a discharge lamp for use in a variety of applications, for example in a lithographic apparatus.

### 2. Description of the Related Art

A lithographic apparatus is a machine that applies a desired pattern onto a target portion of a substrate. Lithographic apparatus can be used, for example, in the manufacture of integrated circuits (ICs). In that circumstance, a patterning device, which is alternatively referred to as a mask or a reticle, may be used to generate a circuit pattern corresponding to an individual layer of the IC, and this pattern can be imaged onto a target portion (e.g. including part of one or several dies) on a substrate (e.g. a silicon wafer) that has a layer of radiation-sensitive material (resist). In general, a single substrate will contain a network of adjacent target portions that are successively exposed. Known lithographic apparatus include steppers, in which each target portion is irradiated by exposing an entire pattern onto the target portion in one go, and scanners, in which each target portion is irradiated by scanning the pattern through the projection beam in a given direction (the "scanning" direction) while synchronously scanning the substrate parallel or anti-parallel to this direction.

Until recently, in such a lithographic apparatus, a discharge lamp, e.g., a mercury discharge lamp, has been used that was not pressurized to a large extent. That means that, in the cold stage of the lamp, the pressure within the discharge lamp was not much below or above atmospheric pressure (10⁵ Pa). However, since the introduction of high-power discharge lamps, some manufactures of those lamps have increased the pressure inside the discharge lamp bulb, in order to increase the efficiency of the energy-to-light transformation. Such high-pressure lamps have a higher intensity at the same electrical power dissipation and produce less heat at the same intensity than lower pressure discharge lamps. Such lamps are manufactured, for example, by Osram and USHIO. The high-pressure discharge lamps may have a positive internal pressure of up to about 8 x 10⁵ Pa when they are not used. Such high pressure discharge lamps may suddenly explode resulting in discharge of quartz and mercury. Also metal fragments may be released. This causes a risk of personal injury and/or damage to other objects. Therefore, these high-pressure discharge lamps should be handled with great care. They should not only be dealt with with great care during operation, where the internal pressure may built up to a pressure as high as 30-75 x 10⁵ Pa, but also during installation of the discharge lamp into a light source, e.g., in a lithographic apparatus. Especially, in a lithographic apparatus, rupture of such a mercury discharge lamp is undesirable because the lithographic apparatus needs be cleaned afterwards. This results in a reduced availability.

In order to avoid this, it is known from the prior art to install such a mercury discharge lamp using a rigid protective cover around the lamp, which is made of a material that can withstand fragments of an exploding lamp. A person installing such a lamp does not touch the lamp itself but uses the rigid protective cover around the lamp to put the discharge lamp in place. However, in some light sources it may be difficult to remove the rigid protective cover after installation of the lamp. Sometimes, a module or socket in which a discharge lamp is to be installed does not provide enough room to remove the rigid protective cover. If so, a complete redesign of this module would be necessary to make this possible.

### SUMMARY OF THE INVENTION

It is an aspect of the present invention to provide a protective cover for a discharge lamp that can be used in more installations than the rigid protective cover known from the prior art and can be removed after the discharge lamp has been installed in more existing arrangements.

According to an aspect of the present invention, a protective cover for a discharge lamp is flexible and made of a material that has a tensile strength such that the protective cover is impermeable for fragments produced from the discharge lamp when the discharge lamp breaks when covered by the protective cover.

By providing a protective cover that is not rigid but flexible, the protective cover can be removed from a discharge lamp by simply sliding it off the discharge lamp just like taking off a sock. This requires far less space than the state of the art method and may prevent the necessity of redesign of modules in which the discharge lamp has to be installed. The protective cover needs to be designed in such a way that fragments from the glass bulb of the discharge lamp flying around after an explosion of the lamp, and possibly some liquid mercury, are stopped by the protective cover. The strength of the flexible material may be in a range between 2.5 and 6 Gpa. In one embodiment the protective cover is made of fibers. Those fibers may be selected from a group of materials including aramid, polyethelene, SPECTRA®, VECTRAN®, PBO, glass, and/or any combination thereof.

Such fibers may either be knit of woven. When woven, the fibers may be biaxially woven. In an embodiment the fibers may be coated with a coating that is chemically inactive in a lithographic apparatus. An example of such a coating is TEFLON® (polytetrafluoroethylene, or PTFE).

In another embodiment the protective cover is itself covered with a flexible layer. The flexible layer may be either located at the inside or the outside of the protective cover, although there may also be a flexible layer both at the inside and at the outside of the lamp. The flexible layer may be made of a synthetic material selected from a group including: PVC, PE and PTFE.

The present invention also relates to a set including a discharge lamp and a protective cover, wherein the protective cover is flexible and made of a material that has a tensile strength such that the protective cover is impermeable for fragments produced from the discharge lamp when the discharge lamp breaks when covered by the protective cover.

Moreover, the present invention relates to a method of installing a source in a lithographic apparatus, the method including providing a discharge lamp; providing a protective cover on the discharge lamp, the protective cover being flexible and made of a material that has a tensile strength such that the protective cover is impermeable for fragments produced from the discharge lamp when the discharge lamp breaks when covered by the protective cover; installing the discharge lamp in a light source of the lithographic apparatus while the protective cover is still on the discharge lamp; and removing the protective cover after the discharge lamp is installed.

Additionally, the present invention relates to a device manufacturing method including: providing a discharge lamp; providing a protective cover on the discharge lamp, the protective cover being flexible and made of a material that has a tensile strength such that the protective cover is impermeable for fragments produced from the discharge lamp when the discharge lamp breaks when covered by the protective cover; installing the discharge lamp in a light source while the protective cover is still on the discharge lamp; removing the protective cover after the discharge lamp is installed; and projecting a patterned beam of radiation onto a target portion of a substrate.

The protective cover according to the present invention may be used with mercury discharge lamps in a so-called "i-line" lithographic apparatus. The i-line corresponds to a radiation wavelength of 365 nm. However, the invention is not restricted to this. The cover can be used to protect any type of discharge lamp that has a risk of breaking or exploding during installation, e.g., discharge lamps in flood lights in stadiums.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. It should be appreciated that in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning device" used herein should be broadly interpreted as referring to a device that can be used to impart a beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit. Patterning device may be transmissive or reflective. Examples of patterning device include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. In this manner the reflected beam is patterned.

The support supports, e.g. bares the weight of, the patterning device. It holds the patterning device in a way depending on the orientation of the patterning device, the design of the lithographic apparatus, and other conditions, for example whether or not the patterning device is held in a vacuum environment. The support can use mechanical clamping, vacuum, or other clamping techniques, for example electrostatic clamping under vacuum conditions. The support may be a frame or a table, for example, which may be fixed or movable as required and which may ensure that the patterning device is at a desired position, for example with respect to the projection system. Any use of the terms "reticle" or "mask" herein may be considered synonymous with the more general term "patterning device".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

The cover for a discharge lamp of the present invention may be used for installing a discharge lamp in a lithographic apparatus as defined above. However, the protective cover may also be used to install such a discharge lamp in any other type of arrangement.

### BRIEF DESCRIPTION OF THE DRAWINGS

Embodiments of the present invention will now be described, by way of example only, with reference to the accompanying schematic drawings in which corresponding reference symbols indicate corresponding parts, and in which:

Figure 1 depicts a lithographic apparatus according to an embodiment of the present invention;

Figure 2 depicts a light source that may be used in the lithographic apparatus of Figure 1;

Figure 3 depicts a mercury discharge lamp that may be used in the light source of Figure 2;

Figure 4a depicts a protective lamp cover according to an embodiment of the present invention; and

Figure 4b depicts the protective lamp cover of Figure 4a in use, i.e., when covering a discharge lamp.

### DETAILED DESCRIPtION

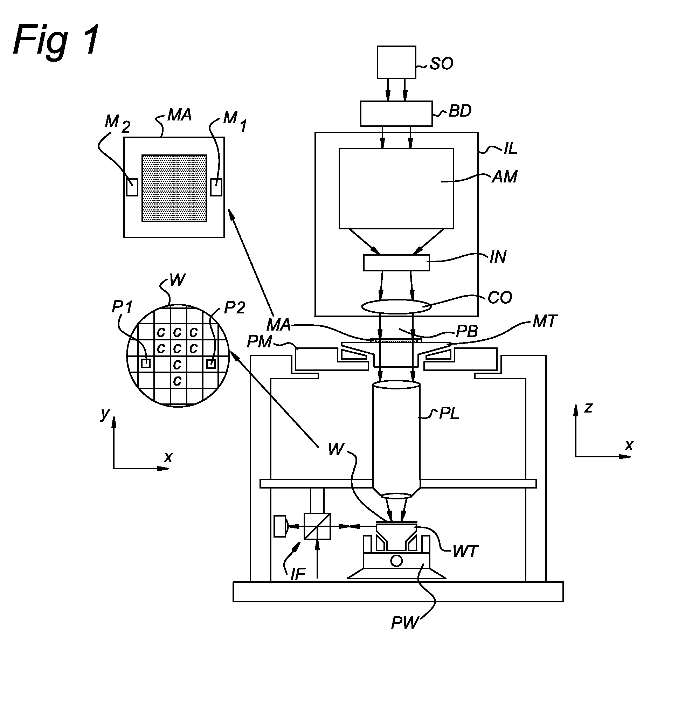

Figure 1 schematically depicts a lithographic apparatus according to an embodiment of the present invention, including an illumination system (illuminator) IL configured to provide a beam PB of radiation, e.g. including visible light, UV radiation, deep ultraviolet (DUV) or extreme ultraviolet (EUV) radiation. In an embodiment of the present invention, a discharge lamp is used to produce the radiation. The radiation will have a wavelength in the UV range or higher. A wavelength produced may be so-called i-line radiation having a wavelength of 365 nm. A first support (e.g. a mask table) MT is configured to support a patterning device (e.g. a mask) MA and is connected to a first positioning device PM that accurately positions the patterning device with respect to a projection system ("lens") PL. A substrate table (e.g. a wafer table) WT is configured to hold a substrate (e.g. a resist-coated wafer) W and is connected to a second positioning device PW that accurately positions the substrate with respect to the projection system PL. The projection system (e.g. a refractive projection lens) PL images a pattern imparted to the beam PB by the patterning device MA onto a target portion C (e.g. including one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives radiation from a radiation source SO. The source and the lithographic apparatus may be separate entities, for example when the source is an excimer laser. In such cases, the source is not considered to form part of the lithographic apparatus and the radiation is passed from the source SO to the illuminator IL with the aid of a beam delivery system BD including, for example, suitable directing mirrors and/or a beam expander. In other cases the source may be integral part of the apparatus, for example when the source is a mercury discharge lamp. The source SO and the illuminator IL, together with the beam delivery system BD if required, may be referred to as a radiation system.

The illuminator IL may include an adjusting device AM configured to adjust the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally includes various other components, such as an integrator IN and a condenser CO. The illuminator provides a conditioned beam of radiation PB having a desired uniformity and intensity distribution in its cross-section.

The beam PB is incident on the mask MA, which is held on the mask table MT. Having traversed the mask MA, the beam PB passes through the projection system PL, which focuses the beam onto a target portion C of the substrate W. With the aid of the second positioning device PW and a position sensor IF (e.g. an interferometric device), the substrate table WT can be moved accurately to position different target portions C in the path of the beam PB. Similarly, the first positioning device PM and another position sensor (e.g. an interferometric device which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning devices PM and PW. However, in the case of a stepper, as opposed to a scanner, the mask table MT may be connected to a short stroke actuator only, or may be fixed. The mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C at once (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width in the non-scanning direction of the target portion in a single dynamic exposure, whereas the length of the scanning motion determines the height in the scanning direction of the target portion.
3. In another mode, the mask table MT is kept essentially stationary holding a programmable patterning device, and the substrate table WT is moved or scanned while a pattern imparted to the beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

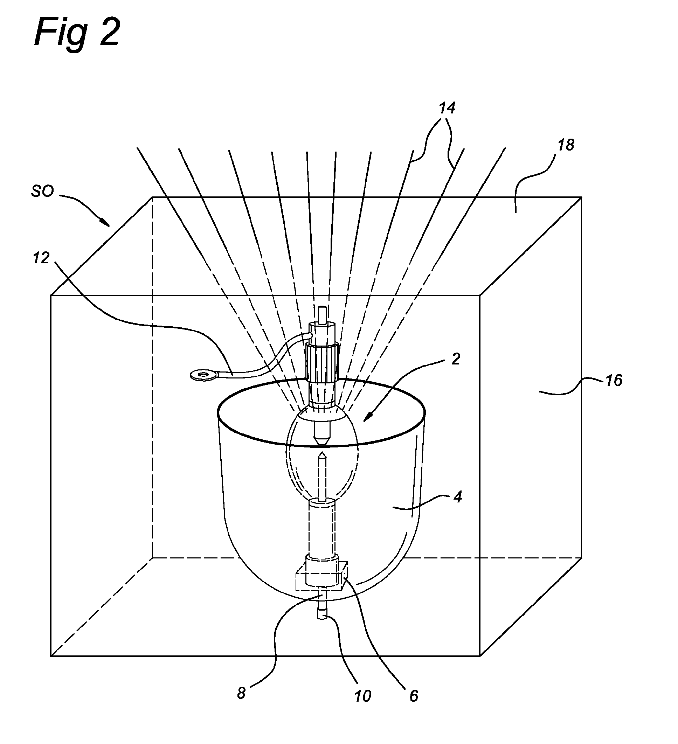

Figure 2 shows a source SO that may be used in the apparatus of Figure 1. The source SO includes an enclosure 16. The enclosure 16 has at least one open surface 18 allowing radiation 14 produced by a lamp 2 to propagate from the source SO to the environment.

The enclosure 16 is configured to support a socket 6. The socket 6 is arranged to receive a fitting 8 of lamp 2. The lamp fitting 8 may be any type of fitting, e.g., a threaded type or a bayonet catch type.

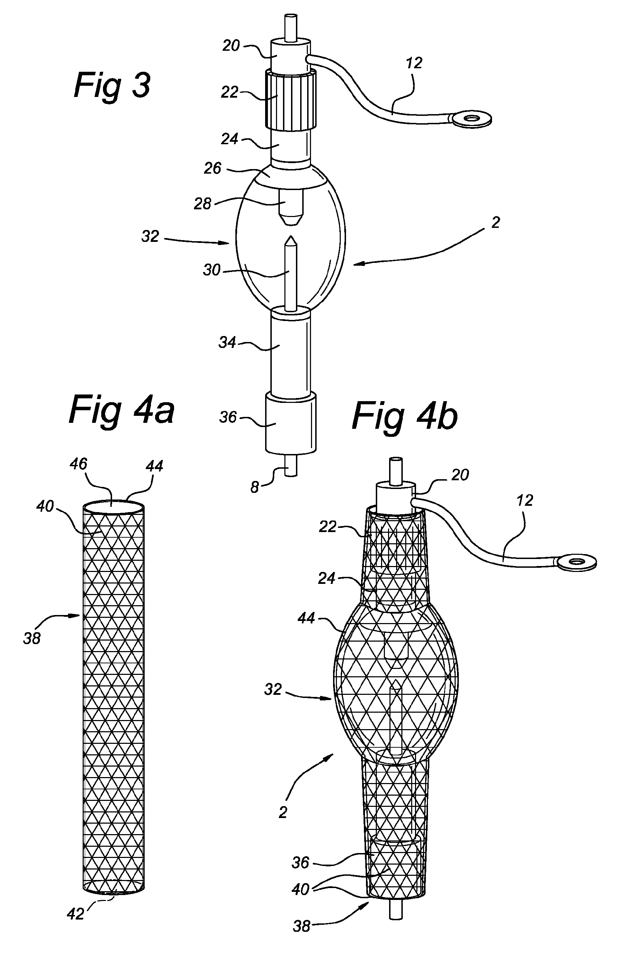

The lamp 2 may be a high-pressure mercury discharge lamp. The lamp 2 is only schematically shown in Figure 2. Details of the lamp 2 are shown in Figure 3. The lamp 2 has two terminals, the fitting 8 that functions as an external cathode terminal and an external anode terminal 12. The fitting is, in use, connected to a connection 10. The connection 10 and the terminal 12 are, in use, connected to a suitable power supply (not shown).

Referring again to Figure 2, the discharge lamp 2 is surrounded by a reflector 4. The reflector 4 may have an elliptical shape.

Referring again to Figure 3, the discharge lamp 2 includes the lamp fitting 8 for installing the discharge lamp 2 in the socket 6. The lamp fitting 8 is connected to a base 36. The base 36 is made of an insulation material. The base 36 is fixed to a cathode bulb part 34 that is part of a bulb 32 which also has an anode bulb part 24 at its other side. The cathode bulb part 34, the bulb 32 and the anode bulb part 24 are made of the same material. When the lamp 2 is a mercury discharge lamp, the bulb 32 will be made of quartz.

Cooling fms 22 are provided on the anode bulb part 24 to improve cooling of the lamp 2 in use. The anode bulb part 24 is connected to a base 20 that is also connected to the external anode terminal 12. An anode 28 and a cathode 30 are provided within the bulb 32. A heat reflection layer 26 is provided at the inner side of the glass bulb 32 behind the anode 28.

The lamp 2 may be one of the HBO® mercury short arc lamps for microlithography as available from OSRAM. However, other manufacturers, for example USHIO produce similar lamps. The present invention may be used for discharge lamps producing so-called i-line, i.e., radiation with a wavelength of 365 nm. Such discharge lamps have a positive internal pressure even in their cold state, i.e., at room temperature. As discussed above, such lamps may explode during installation resulting in a high risk of personal injury or damage to components in the neighborhood of the source SO.

To reduce these risks, the present invention provides a protective cover 38 as shown in Figure 4a. The protective cover 38 has an open lower side 42 and an open upper side 46. The protective cover 38 is manufactured so that it is flexible. Out of use, it may have the shape of a cylinder as shown in Figure 4a. However, it is made such that it can be slid on a lamp 2 so that it takes the form of the lamp 2, as shown in Figure 4b. The protective cover 38 may be designed so that, in use, it fits suckingly around the lamp 2.

The protective lamp cover 38 may be made of a material that has a strength so that the protective cover is impermeable for fragments produced from the lamp 2 when the lamp ruptures or explodes during installation of the lamp 2 in the socket 6 when the lamp 2 is covered by the protective cover 38. The material may have a strength in the range between 2.5 and 6 Gpa. Maximum tensile strain may be 2% or larger.

The material may consist of fibers 40. The fibers may be selected from a group of materials including aramid, polyethylene, SPECTRA@, VECTRAN®, PBO, glass, and any combination thereof. The polyethylene may be formed as spun polyethylene fibers and may be available under the trademark DYNEEMA®. Aramid is available under the trademark KEVLAR® or TWARON®, and PBO is available under the trademark ZYLON®.

In order to provide such a protective cover with enough flexibility, the protective cover 38 may be knit or woven. Of course, the fibers must be knit or woven so that they are close enough to one another to prevent fragments, for example glass fragments, produced after an explosion of the discharge lamp from leaving the protective cover. To that end, the spaces between adjacent fibers may not be larger than 3 mm. The fibers may be biaxially woven.

In order to prevent contamination of a lithographic apparatus when the protective cover 38 is used for installing a lamp in a lithographic apparatus, the fibers may be coated with a coating that is chemically inactive in the lithographic apparatus. Such a coating may be any suitable coating, for example TEFLON®.

In order to prevent mercury, or other materials, from escaping from the lamp 2 into, for example a lithographic apparatus, after rupture of the lamp 2, the protective cover 38 may be covered or lined with a flexible layer 44. In Figure 4a, the flexible layer 44 is shown on the inside of the protective cover 38. However, the flexible layer 44 may be on the outside of the protective cover 38 instead. Moreover, there may be a flexible layer on both the inside and the outside of the protective cover 38. The flexible layer 44 may be made of a synthetic material selected from a group including PVC, PE and PTFE. However, other polymers may be used instead.

Referring to Figure 4b, the protective cover 38 covers the lamp 2 and takes the form of the lamp 2. The protective cover 38 should be long enough to cover at least all the glass parts of the lamp 2, e.g. the bulb 32, as shown in Figure 4b.

As shown in Figure 4b, the cover 38 does not cover the external anode terminal 12. However, the cover 38 may be long enough to cover the external anode terminal 12. In such a situation, one side of the cover 38, e.g. the upper side 46 as shown in Figures 4a and 4b, may be closed, whereas the cover 38 then has only one side 42 that is open such that the lamp cover 38 can be slid on and off the discharge lamp 2 via the open side 42.

The protective cover according to the invention is used in the following way: the protective cover 38 is slid on the lamp 2; the lamp 2 is installed in the source SO while the protective cover 38 is still on the lamp 2; the protective cover 38 is removed from the lamp 2 after the lamp 2 is installed.

After the lamp 2 has been installed in such a way in a lithographic apparatus, the lithographic apparatus may be used to produce a semiconductor device by providing a substrate in the lithographic apparatus, providing a beam using radiation produced by the source SO and the illumination system IL, using the patterning device MA to impart the projection beam with a pattern at it's cross-section and projecting the patterned beam of radiation onto a target portion of the substrate.

While specific embodiments of the present invention have been described above, it will be appreciated that the invention may be practiced otherwise than as described. The description is not intended to limit the invention.

## Claims

1. A protective cover for a discharge lamp, wherein the protective cover is flexible and made of a material that has a tensile strength so that the protective cover is impermeable for fragments produced from the discharge lamp when the discharge lamp breaks when covered by the protective cover.

2. A protective cover according to claim 1, wherein the tensile strength is in a range between about 2.5 and 6 Gpa.

3. A protective cover according to claim 1, wherein the protective cover is made of fibers.

4. A protective cover according to claim 3, wherein the fibers are selected from a group of materials comprising aramid, polyethene, SPECTRA®, VECTRAN®, PBO, glass, and any combination thereof.

5. A protective cover according to claim 3, wherein the fibers are knit or woven.

6. A protective cover according to claim 3, wherein the fibers are biaxially woven.

7. A protective cover according to claim 3, wherein fibers are coated with a coating that is chemically inactive in a lithographic apparatus.

8. A protective cover according to claim 7, wherein the coating is PTFE.

9. A protective cover according to claim 1, wherein the protective cover is covered with a flexible layer.

10. A protective cover according to claim 9, wherein the flexible layer is located at at least one of an inside and outside of the protective cover.

11. A protective cover according to claim 9, wherein the flexible layer is made of a polymer.

12. A protective cover according to claim 11, wherein the flexible layer is made of a polymer selected from a group comprising PE, PVC or PTFE.

13. A set comprising a discharge lamp and a protective cover, wherein the protective cover is flexible and made of a material that has a tensile strength so that the protective cover is impermeable for fragments produced from the discharge lamp when the discharge lamp breaks when covered by the protective cover.

14. A set according to claim 13, wherein the discharge lamp comprises parts made of glass and the protective cover is long enough to protect all the parts made of glass.

15. A method of installing a source in a lithographic apparatus, the method comprising:
providing a discharge lamp;
providing a protective cover on the discharge lamp, the protective cover being flexible and made of a material that has a tensile strength so that the protective cover is impermeable for fragments produced from the discharge lamp when the discharge lamp breaks when covered by the protective cover;
installing the discharge lamp in a light source of the lithographic apparatus while the protective cover is still on the discharge lamp;
removing the protective cover after the discharge lamp is installed.

16. A method according to claim 15, wherein the lithographic apparatus comprises:
the light source configured to produce radiation;
an illumination system configured to provide a beam based on the radiation;
a support configured to support a patterning device, the patterning device configured to impart the projection beam with a pattern in its cross-section;
a substrate table configured to hold a substrate; and
a projection system configured to project the patterned beam onto a target portion of the substrate.

17. A device manufacturing method, comprising:
providing a discharge lamp;
providing a protective cover on the discharge lamp, the protective cover being flexible and made of a material that has a tensile strength so that the protective cover is impermeable for fragments produced from the discharge lamp when the discharge lamp breaks when covered by the protective cover;
installing the discharge lamp in a light source while the protective cover is still on the discharge lamp;
removing the protective cover after the discharge lamp is installed; and
projecting a patterned beam of radiation onto a target portion of a substrate.

18. A device manufactured according to the method of claim 17.
